Europäisches Patentamt

European Patent Office

Office européen des brevets

(11) Veröffentlichungsnummer: **0 082 811**

**A1**

(12) # EUROPÄISCHE PATENTANMELDUNG

(21) Anmeldenummer: **82810501.5**

(22) Anmeldetag: **23.11.82**

(51) Int. Cl.³: **G 01 B 13/10**
**G 01 L 9/12, G 01 R 27/26**

(30) Priorität: **10.12.81 CH 7874/81**

(43) Veröffentlichungstag der Anmeldung:
**29.06.83 Patentblatt 83/26**

(84) Benannte Vertragsstaaten:
**DE FR GB IT**

(71) Anmelder: **Fritz Studer AG**
**Glockenthal**
**CH-3601 Thun(CH)**

(72) Erfinder: **Abbuehl, Hermann**
**Klosternweg 17**
**CH-3612 Steffisburg(CH)**

(54) **Pneumatisch-elektrische Längenmessvorrichtung.**

(57) Pneumatisch- elektrische Längenmessvorrichtung, vorzugsweise für das Messen von Bohrungen (8), dadurch gekennzeichnet, dass die Messwertumwandlungen vom weganalogen, pneumatischen Signal durch die Aenderung der Dielektrizitätszahl $\leq$ des Messgases in einer kapazitiven Messkammer (5) in Funktion vom pneumatischen Druck in derselben durchgeführt wird.

Druckschwankungen in der Speiseluft sowie Schwankungen der Dielektrizitätszahl werden in einer zu der Messkammer (5) pneumatischen parallel geschalteten Kompensationskammer (10) kompensiert.

Fig.1

EP 0 082 811 A1

## II. BESCHREIBUNG

Pneumatische Längenmessung, insbesonders das pneumatische Messen von Bohrungen ist Stand der Technik.

Normalerweise wird pneumatisches Messen von Längen, insbesonders pneumatisches Messen von Bohrungen derart durchgeführt, dass ein Messdorn, welcher an der zu messenden Position eine Ausströmdüse für das Messgas enthält, in die Bohrung eingeführt wird. Bei gegebenem Bohrungsdurchmesser strömt nun eine definierte Menge Messgas aus der Ausströmdüse und zwischen Bohrung und Messdorn in die Atmosphäre.

Je nach Durchmesser der Bohrung und entsprechend dem Spalt zwischen Bohrung und Messdorn verändert sich die ausströmende Gasmenge und der Messgasdruck in der Gaszuführung zum Messdorn.
Diese Messgasdruckdifferenz dient als Mass für den entsprechenden Bohrungsdurchmesser und wirkt über die Membrane eines Differenzdruckmanometers. Die Membrane dieses Differenzdruckmanometers wird nun proportional zum jeweiligen Bohrungsdurchmesser verschoben und diese Verschiebung wird mittels eines elektrischen Wegmesssystems in ein wegproportionales elektrisches Signal umgewandelt.

Der Nachteil dieses Systems liegt nun darin, dass ein Weg, nämlich die Durchmesserdifferenz zwischen Bohrung und Messdorn zuerst in ein pneumatisches Signal, dieses anschliessend an der Druckdifferenzmembran wieder in ein mechanisches Signal und anschliessend durch ein mechanisch- elektrisches Wegmesssystem gewandelt wird.
- Also eine relativ Lange und fehlerhafte Prozesskette: Wegsignal - pneumtaisches Signal - Wegsignal - elektrisches Signal.

Eine direkte mechanische Messung mit Umwandlung in ein elektrisches Signal durch einen Tastmechanismus ist in kleinen Bohrungen der kleinen Abmessungen der Mechanik wegen sehr schwer zu realisieren. Ausserdem übt die pneumatische Messung von Bohrungen während des Messvorganges zusätzlich einen Reinigungsvorgang der Bohrung aus, weshalb das pneumatische Messen am Beginn der Messkette beibehalten werden sollte.

Der Erfindung liegt nun die Aufgabe zugrunde, diese lange Signalkette zu verkürzen und dadurch die Längenmessung und insbesonders die Messung von Bohrungen zuverlässiger und billiger zu gestalten.

Erfindungsgemäss wird dies dadurch erreicht, dass die Messwertumwandlung vom weganalogen, pneumatischen Signal in ein elektrisches Signal durch die Aenderung der Dielektrizitätszahl des Messgases in einer kapazitiven Messkammer in Funktion vom pneumatischen Druck in derselben durchgeführt wird. Zu der die Druckänderungen feststellenden Messkammer ist eine parallel zu derselben geschaltete zweite Messkammer derart angeordnet, dass sie die Kompensation der Schwankungen des Speisegasdruckes sowie der Feuchtigkeit und Temperatur des Messgases bewirkt.

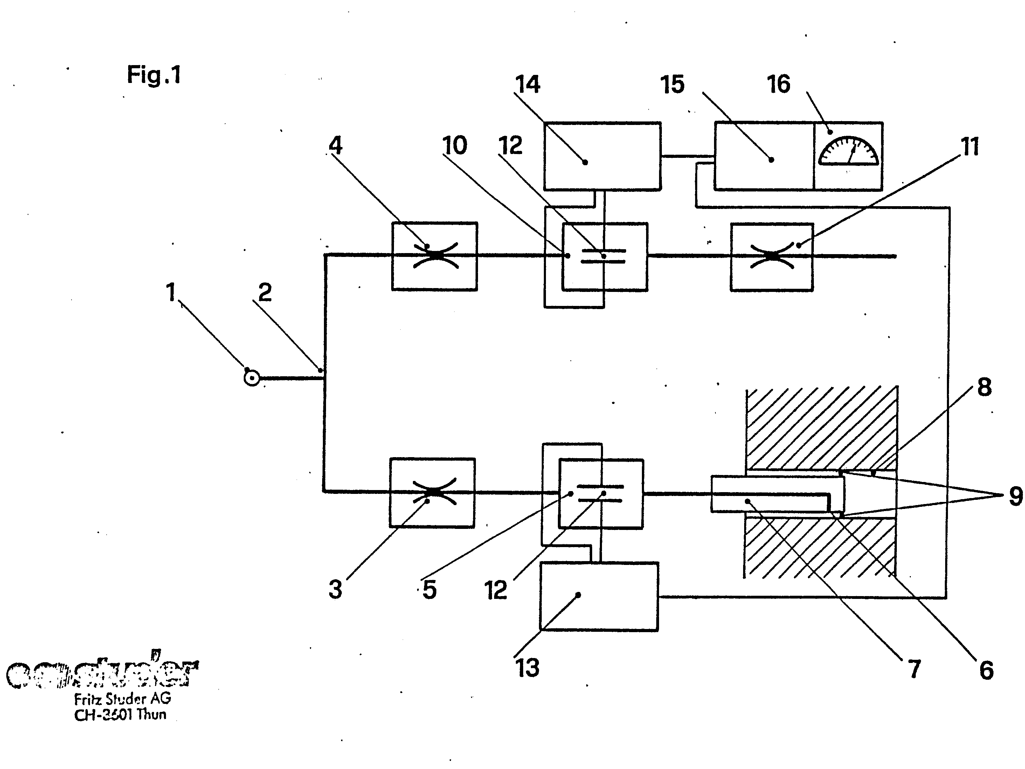

Im Folgenden wird an Hand der beiliegenden schematischen Zeichnung Fig. 1 die Luftpneumatisch- elektrische Längenmessvorrichtung, die hier für die Messung von Bohrungen ausgelegt ist, beschrieben:

Bei Luftspeiseanschluss 1 wird die für den Messvorgang vorbereitete Speiseluft mit dem Eingangsdruck Pi in das pneumatische System eingeführt. Die Verzweigung 2 verteilt die Speiseluft mit gleichem Druck auf die Eingangsdrossel 3 der Messlinie und auf die Eingangsdrossel 4 der Kompensationslinie. In der Messlinie strömt die Luft durch die Messkammer 5 und anschliessend durch die Messdüse 6 des Messdornes 7 und den durch das Spiel zwischen Messdorn 7 und Bohrung 8 gebildeten Spalt 9 in die Atmosphäre.

In der Kompensationslinie strömt die Luft durch die Kompensationskammer 10 und anschliessend durch die Ausgangsdrossel 11
in die Atmosphäre.
Sowohl in der Messkammer 5 als auch in der Kompensationskammer
10 befindet sich eine Kondensatoranordnung 12.
Die Kapazität C von Kondensatoren ist $C = \dfrac{\leq \cdot F}{a}$

wobei $\leq$ die Dielektrizitätskonstante des Mediums zwischen den
Kondensatorenplatten, F die Fläche der Kondensatorenplatten und a
der Abstand der Kondensatorenplatten ist. Da die Kapazität C der
jeweiligen Kondensatorenanordnung 12 in der Messkammer 5 und der
Kompensationskammer 10 direkt durch die Kapazitätsmessgeräte 13
und 14 gemessen werden kann, lassen sich die zugehörigen Dielektrizitätswerte 2 und daraus die entsprechenden Gasdrücke in den Kammern 5 und 10 bestimmen. Die Kompensationskammer 10 dient dabei
dazu, Druckschwankungen in der Speiseluft sowie Dielektrizitätszahländerungen infolge von Schwankungen des Speiseluftzustandes in
der gesammten pneumatischen Messanordnung zu kompensieren.
Während der Luftdruck in der Kompensationskammer 10 zu Kompensationszwecken durch die Eingangsdrossel 4 und die Ausgangsdrossel 11
weitgehend konstant gehalten wird, ändert sich der Druck in der
Messkammer 5. Dieser Druckwert wird durch die Grösse des Spaltes 9
zwischen Messdorn 7 und Bohrung 8 bestimmt und stellt, da der
Druckmesser des Messdornes 7 konstant bleibt, einen Messwert für
die zubestimmende Durchmessergrösse der Bohrung 8 dar.

Sowohl der in der Messkammer 5 mittels des Kapazitätsmessgerätes 13
gemessene Bohrungsmesswert als auch der in der Kompensationskammer
10 mittels des Kapazitätsmessgerätes 14 gemessene Kompensationswert
werden im Vergleichsgerät 15 verglichen und der kompensierte Bohrungsmesswert gelangt im Anzeigegerät 16 zur Anzeige oder kann als
Information weiter verarbeitet werden.

Unlinearitäten infolge der geometrischen und pneumatischen Verhältnisse an dem in der Bohrung 9 befindlichen Messdornes 7 können im Vergleichsgerät 15 elektrisch linearisiert werden.

Die in dieser Erfindung beschriebene pneumatisch- elektrische Längenmessvorrichtung ermöglicht die direkte Wandlung des pneumatischen Signals in ein elektrisches weiter verarbeitbares Signal. Dadurch wird die Messprozesskette kurz und weniger fehlerbehaftet.

Fritz Studer AG
CH-3601 Thun

0082811

FRITZ STUDER AG
CH-3601 THUN


I. PATENTANSPRUECHE


1. Pneumatisch- elektrische Längenmessvorrichtung, vorzugsweise für
   das Messen von Bohrungen, dadurch gekennzeichnet, dass die Messwertumwandlung vom weganalogen, pneumatischen Signal in ein elektrisches Signal durch die Aenderung der Dielektrizitätszahl des
   Messgases in einer kapazitiven Messkammer in Funktion vom pneumatischen Druck in derselben durchgeführt wird.


2. Pneumatisch- elektrische Längenmessvorrichtung, nach Patentanspruch 1, dadurch gekennzeichnet, dass zu der die Druckänderungen
   feststellenden Messkammer eine parallel zu derselben geschaltete
   zweite Messkammer derart angeordnet ist, dass sie die Kompensation
   der Schwankungen des Speisegasdruckes sowie der Feuchtigkeit und
   der Temperatur des Messgases bewirkt.


3. Pneumatisch- elektrische Längenmessvorrichtung, nach Patentanspruch 1 und 2, dadurch gekennzeichnet, dass géometrische und
   pneumatische Nichtlinearitäten an den Messgeräten, insbesonders
   an Messdornen und an den pneumatisch- elektrischen Wandlern elektrisch linearisiert werden.


4. Pneumatisch- elektrische Längenmessvorrichtung nach Patentanspruch 1, 2 und 3, dadurch gekennzeichnet, dass als Gas zur pneumatischen Messung Luft verwendet wird.

0082811

5. Pneumatisch- elektrische Längenmessung nach Patentanspruch 1, 2, 3 und 4, dadurch gekennzeichnet, dass Druckschwankungen im Speisegas sowie Dielektrizitätszahländerungen infolge Schwankungen des Speisegaszustandes in einer zu der Messkammer pneumatisch parallel geschalteten Kompensationskammer kompensiert werden.

Fritz Studer AG
CH-3601 Thun

Fig.1

0082811

# 0082811

**EUROPÄISCHER RECHERCHENBERICHT**

Nummer der Anmeldung

EP 82 81 0501

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | --- | | G 01 B 13/10 |
| Y | GB-A- 913 700 (LABORATOIRE DES BASSES PRESSIONS) * Anspruch 1 * | 1 | G 01 L 9/12 G 01 R 27/26 |
| A | * Anspruch 4 * | 2 | |
| | --- | | |
| Y | DE-A-2 134 772 (ATOMENERGIKOMISSIONEN) * Ansprüche * | 1 | |
| | --- | | |
| A | US-A-4 088 009 (A. FUKUDA) * Zusammenfassung ; Anspruch * | 2,4 | |
| | ----- | | |

**RECHERCHIERTE SACHGEBIETE (Int. Cl. ³)**

G 01 B 13/00
G 01 L 9/12
G 01 R 27/26

Der vorliegende Recherchenbericht wurde für alle Patentansprüche erstellt.

| Recherchenort BERLIN | Abschlußdatum der Recherche 17-02-1983 | Prüfer KOEHN G |
|---|---|---|

EPA Form 1503. 03 82